# EUROPEAN PATENT APPLICATION

(11) **EP 1 798 784 A2**
(43) Date of publication of application: **20.06.2007**
(21) Application number: 06256370.5
(22) Date of filing: 14.12.2006
(51) Int. Cl.: H01L 51/50

(54) **Organic light emitting device and method of fabricating the same**

(30) Priority: 14.12.2005 KR 20050123222
(71) Applicant: Samsung SDI Co., Ltd., Suwon-si, Gyeonggi-do (KR)
(72) Inventor: Kho, Sam-II, Samsung SDI Co., Ltd., Suwon-si Gyeonggi-do (KR); Yoo, Byeong-Wook, Samsung SDI Co., Ltd., Suwon-si Gyeonggi-do (KR); Sung, Yeun-Joo, Samsung SDI Co., Ltd., Suwon-si Gyeonggi-do (KR); Lee, Jae-Ho, Samsung SDI Co., Ltd., Suwon-si Gyeonggi-do (KR); Lee, Seung-Hyun, Samsung SDI Co., Ltd., Suwon-si Gyeonggi-do (KR); Chang, Seung-Wook, Samsung SDI Co., Ltd., Suwon-si Gyeonggi-do (KR); Yang, Nam-Choul, Samsung SDI Co., Ltd., Suwon-si Gyeonggi-do (KR); Song, Myung-Won, Samsung SDI Co., Ltd., Suwon-si Gyeonggi-do (KR)
(74) Representative: Mounteney, Simon James

(57) **Abstract**

An organic light emitting device which has an anode, i.e. a lower electrode, made of a single metal layer in an upper emission structure, and a method of fabricating the same . The organic light emitting device is constructed with a substrate, an anode disposed on the substrate and including a metal, a metal fluoride layer disposed on the anode, an organic layer disposed on the metal fluoride layer and including at least an organic emission layer, and a cathode disposed on the organic layer.

## Description

### CLAIM OF PRIORITY

### BACKGROUND OF THE INVENTION

### Field of the Invention

The present invention relates to an organic light emitting device and a method of fabricating the same and, more particularly, to an organic light emitting device which has an anode, i.e. a lower electrode made of a single metal layer in an upper emission structure, and a method of fabricating the same.

### Description of the Related Art

Recently, flat panel displays, for example, liquid crystal display devices, organic light emitting display devices and plasma display panels (PDPs), which are free of the typical disadvantages of contemporary display devices such as cathode ray tubes (CRTs), have been receiving a lot of attention.

Since liquid crystal display devices are not self-emissive devices but passive devices, they have limits in brightness, contrast, viewing angle, size and so on. While PDPs are self-emissive devices, they are heavy, have high power consumption, and are complicated to fabricate when compared to other flat panel display devices.

On the other hand, since organic light emitting devices are self-emissive devices, they have an excellent viewing angle and contrast. Also, since they do not need a backlight, they can be made thin and lightweight and have lower power consumption. Moreover, they have advantages such as a fast response speed and an ability to driven by direct current at a low voltage, durable in withstanding external impact because they are made from solids, are operable in a wide range of temperatures, and are relatively simple to manufacture.

In a contemporary organic light emitting device, a substrate made from plastic or insulating glass is provided. A buffer layer is formed on the substrate, and a semiconductor layer is formed on the buffer layer. A gate insulating layer is formed on the entire surface of the substrate.

Subsequently, a gate electrode is formed on the gate insulating layer to correspond to a portion of the semiconductor layer, and an interlayer insulating layer is formed on the entire surface of the substrate.

The interlayer insulating layer and the gate insulating layer are etched to form contact holes. Source and drain electrodes formed on the interlayer insulating layer are connected to the semiconductor layer through the contact holes.

Then, a planarization layer is formed on the entire surface of the substrate. The planarization layer is etched to form a via hole connected to one of the source and drain electrodes, and an anode including a reflective layer and a transparent conductive layer is formed on the planarization layer. Here, the reflective layer may be made from Al, Ag or an alloy of these metals, and the transparent conductive layer may be made from indium tin oxide (ITO) or indium zinc oxide (IZO).

The anode is connected to one of the source and drain electrodes through the via hole.

After that, a pixel defining layer is formed on the substrate. The pixel defining layer is etched in order to expose the anode, and then an organic layer is formed on the exposed anode. The organic layer includes at least an emission layer, and may further include a hole injection layer, a hole transport layer, an electron transport layer or an electron injection layer.

A cathode is formed on the entire surface of the substrate, and thus a contemporary organic light emitting device is completely constructed.

The anode of the contemporary organic light emitting device has a structure in which a transparent conductive layer is stacked on a reflective layer made from a metal. In such a structure, the underlying reflective layer reflects light, and the transparent conductive layer disposed on the reflective layer lowers hole injection barriers.

The device is impaired by, however, a shortcoming such as a decrease in the amount of emitted light due to dark pixels generated by an interaction at an interface between the reflective layer and the transparent conductive layer, and a refractive index of the transparent conductive layer.

### SUMMARY OF THE INVENTION

It is therefore an object of the present invention to provide an improved organic light emitting device.

It is another object of the present invention to provide an organic light emitting device and a method for fabricating the same, which has an anode, i.e. a lower electrode made of a single metal layer in an upper emission structure.

A first aspect of the invention provides an organic light emitting device as set out in claim 1. Preferred features of this aspect of the invention are set out in claims 2 to 6.

A second aspect of the invention proi9vdes a method of fabricating an organic light emitting device as set out in claim 7. Preferred features of this aspect of the invention are set out in claims 8 to 12.

In another exemplary embodiment of the present invention, a method for fabricating an organic light emitting device is provided to prepare a substrate, form an anode on the surface, treat a surface of the anode and forming a metal fluoride layer thereon, form an organic layer including at least an organic emission layer on the metal fluoride layer, and form a cathode on the organic layer.

### BRIEF DESCRIPTION OF THE DRAWINGS

Embodiments of the invention will be described by way of example and with reference to the accompanying drawings, in which:

FIG. 1 is a cross-sectional view of a contemporary organic light emitting device;

FIGS. 2 to 4 are cross-sectional views of an organic light emitting device constructed as a first embodiment of the principles of the present invention; and

FIGS. 5 to 7 are cross-sectional views of an organic light emitting device constructed as a second embodiment of the principles of the present invention.

### DETAILED DESCRIPTION OF THE INVENTION

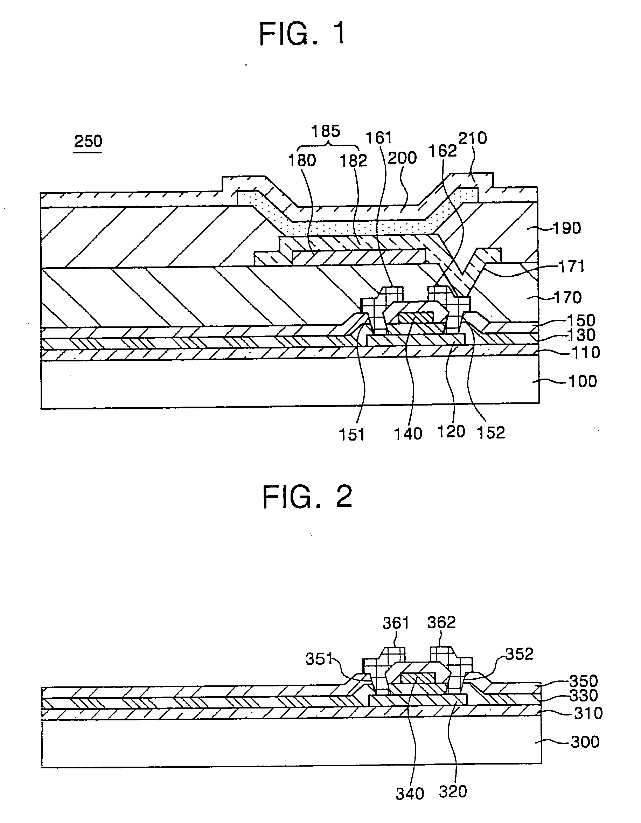

FIG. 1 is a cross-sectional view of a contemporary organic light emitting device.

Referring to FIG. 1, a substrate 100 made from plastic or insulating glass is provided. A buffer layer 110 is formed on substrate 100, and a semiconductor layer 120 is formed on buffer layer 110. A gate insulating layer 130 is formed on the entire surface of substrate 100.

Subsequently, a gate electrode 140 is formed on gate insulating layer 130 to correspond to a portion of semiconductor layer 120, and an interlayer insulating layer 150 is formed on gate electrode 140.

Interlayer insulating layer 150 and gate insulating layer 130 are etched to form contact holes 151 and 152. Source and drain electrodes 161 and 162 are formed on interlayer insulating layer 150. Source and drain electrodes 161 and 162 are connected to semiconductor layer 120 through contact holes 151 and 152, respectively.

Then, a planarization layer 170 is formed on the entire surface of substrate 100. Planarization layer 170 is etched to form a via hole 171 connected to one of source and drain electrodes 161 and 162, and an anode 185 including a reflective layer 180 and a transparent conductive layer 182 is formed on planarization layer 170. Here, reflective layer 180 may be made from Al, Ag or an alloy of these metals, and transparent conductive layer 182 may be made from indium tin oxide (ITO) or indium zinc oxide (IZO).

Anode 185 is connected to one of source and drain electrodes 161 and 162 through via hole 171.

After that, a pixel defining layer 190 is formed on the entire surface of substrate 100. Pixel defining layer 190 is etched in order to expose anode 185, and then an organic layer 200 is formed on the exposed anode 185. Organic layer 200 is constructed with at least an emission layer, and may be further constructed with a hole injection layer, a hole transport layer, an electron transport layer or an electron injection layer.

A cathode 210 is formed on the entire surface of substrate 100, and thus a contemporary organic light emitting device 250 is completely constructed.

The anode 185 of the contemporary organic light emitting device 250 has a structure in which a transparent conductive layer 182 is stacked on a reflective layer 180 made from a metal. In such a structure, the underlying reflective layer 180 reflects light, and transparent conductive layer 182 disposed on reflective layer 180 lowers hole injection barriers.

This device, however, has a shortcoming resulting in a decrease in the amount of light emitted. This is due to dark pixels generated by an interaction at the interface between reflective layer 180 and transparent conductive layer 182, and the refractive index of transparent conductive layer 182.

The present invention will now be described more fully hereinafter with reference to the accompanying drawings, in which embodiments of the principles of the present invention are shown. In the drawings, the thicknesses of layers and regions are exaggerated for clarity. The same reference numerals are used to denote the same elements throughout the specification.

FIGS. 2 to 4 are cross-sectional views of an organic light emitting device constructed as a first embodiment of the present invention.

Referring to FIG. 2, a substrate 300 is provided, which may be an insulating glass, conductive or plastic substrate. A buffer layer 310 is formed on substrate 300. Buffer layer 310 may be a silicon oxide layer, a silicon nitride layer or a combination of these layers. A semiconductor layer 320 is formed on buffer layer 310. Semiconductor layer 320 may be made from amorphous silicon or polycrystalline silicon into which amorphous silicon is crystallized.

Then, a gate insulating layer 330 is formed on the entire surface of substrate 300. Gate insulating layer 330 may be a silicon oxide layer, a silicon nitride layer or a combination of these layers.

A gate electrode 340 is formed on gate insulating layer 330 to correspond to a portion of semiconductor layer 320. Gate electrode 340 may be made from Al, Cu or Cr. An interlayer insulating layer 350 is formed on the entire surface of substrate 300, and may be a silicon oxide layer, a silicon nitride layer or a combination of these layers.

Subsequently, interlayer insulating layer 350 and gate insulating layer 330 are etched to form contact holes 351 and 352 exposing semiconductor layer 320. Source and drain electrodes 361 and 362 are formed on interlayer insulating layer 350. Source and drain electrodes 361 and 362 may be made from materials selected from the group of Mo, Cr, Al, Ti, Au, Pd and Ag. Also, source and drain electrodes 361 and 362 are connected to semiconductor layer 320 through contact holes 351 and 352, respectively.

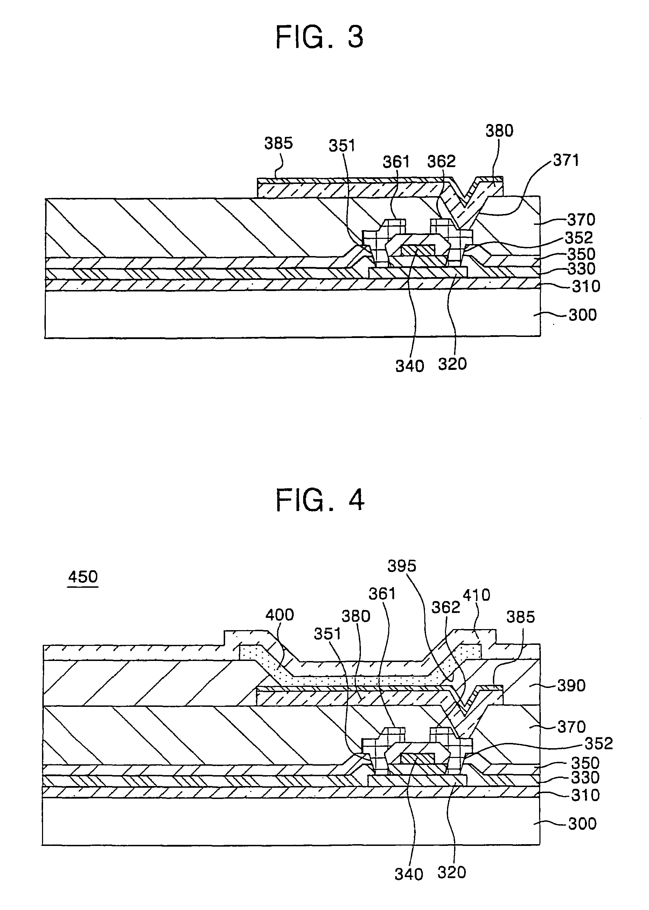

Referring to FIG. 3, planarization layer 370 is formed on the entire surface of substrate 300. Planarization layer 370 may be made from materials selected from the group of polyacrylates resin, epoxy resin, phenolic resin, polyamides resin, polyimides resin, unsaturated polyesters resin, poly(phenylenethers) resin, poly(phenylenesulfides) resin, and benzocyclobutene (BCB).

Planarization layer 370 is constructed with via hole 371 exposing one of source and drain electrodes 361 and 362.

Hereafter, in the present invention, an anode 380 is made from a conductive material with reflective properties. This is because in the contemporary top emission structure as depicted in FIG. 1, when anode 185 is made from a double layer including a transparent conductive oxide layer 182 and a reflective layer 180, fabrication processes are complicated and materials for anode electrode 185 are restricted.

Accordingly, in the present invention, anode 380 is made from a conductive material with single reflection properties, and thus a transparent conductive layer is not necessary.

In this case, a metal is preferable for the conductive material with the reflective properties, and may contain one selected from the group of Ag, an Ag alloy, Al, an Al alloy, Au, Pt, Cu and Sn. Anode 380 is formed by depositing and then patterning a conductive material on substrate 300.

Here, anode 380 may be formed by sputtering. Also, anode 380 may be formed to a thickness between approximately 500 Å to approximately 2000 Å in order to have appropriate reflective properties. This is because, when the thickness of anode 380 is less than 500 Å, it is difficult to endow anode 380 with appropriate reflective properties, whereas when the thickness of anode 380 is greater than 2000 Å, the stress of the film increases and adhesion between anode 380 and an organic layer 400 subsequently stacked on anode 380 or between anode 380 and planarization layer 370 disposed under anode 380 is lowered.

The present invention, however, uses an anode 380 with reflective properties, and thus cannot satisfy a work function condition required for an anode.

Accordingly, to increase the work function of an anode 380 with reflective properties according to the principles of the present invention, surface treatment is performed on a surface of anode 380. Anode 380 may be surface-treated by a plasma method using CF₃ gas or SF₆ gas, both of which contains fluorine.

When anode 380 is processed in such a manner, a metal fluoride layer 385 is formed on the surface of anode 380. In metal fluoride layer 385, the metal atom and the fluorine atom are covalent-bonded, and thus a molecule constituting metal fluoride layer 385 has a dipole moment. Here, the dipole moment may have an orientation from a positive pole to a negative pole, thereby effectively lowering hole injection barriers. Fluorine has a large dipole moment, so CF₃ gas or SF₆ gas which contains fluorine can be used as a source of the plasma method.

Here, metal fluoride layer 385 may be formed to have a thickness of between approximately 1 nm and approximately 1.5 nm. When the thickness of metal fluoride layer 385 is 1 nm or less, injected electric charges cannot tunnel through metal fluoride layer 385, whereas when the thickness of metal fluoride layer 385 is 1.5 nm or more, the injected electric charges can tunnel through metal fluoride layer 385, although the driving voltage increases.

Thus, when anode 380 is surface-treated by a plasma method using CF₃ gas or SF₆ gas containing fluorine and having a large dipole moment, hole injection barriers existing between the anode and the hole injection layer are lowered, and thus the movement of holes is eased.

As such, anode 380 is surface-treated by the plasma method using CF₃ gas or SF₆ gas containing fluorine, so that a single metal layer may be used as anode 380, thereby improving luminous efficiency.

Referring to FIG. 4, a pixel defining layer 390 is formed on the entire surface of substrate 300. Pixel defining layer 390 may be made from one selected from the group of polyacrylates resin, epoxy resin, phenolic resin, polyamides resin, polyimides resin, unsaturated polyesters resin, poly(phenylenethers) resin, poly(phenylenesulfides) resin, and benzocyclobutene (BCB). Here, an opening 395 is formed to expose anode 380.

Subsequently, an organic layer 400 is formed on anode 380 exposed by opening 395 of pixel defining layer 390. Organic layer 400 is constructed with at least an emission layer, and may further include a hole injection layer, a hole transport layer, an electron transport layer or an electron injection layer.

A cathode 410 is formed on the entire surface of substrate 300. Cathode 410 may be made from materials selected from the group of Al, Ag, Mg, Au, Ca and Cr.

Therefore, an organic light emitting device 450 is constructed. Anode 380 is surface-treated by a plasma method using fluorine, so that a single metal layer may be used as anode 380 and thus luminous efficiency may be improved.

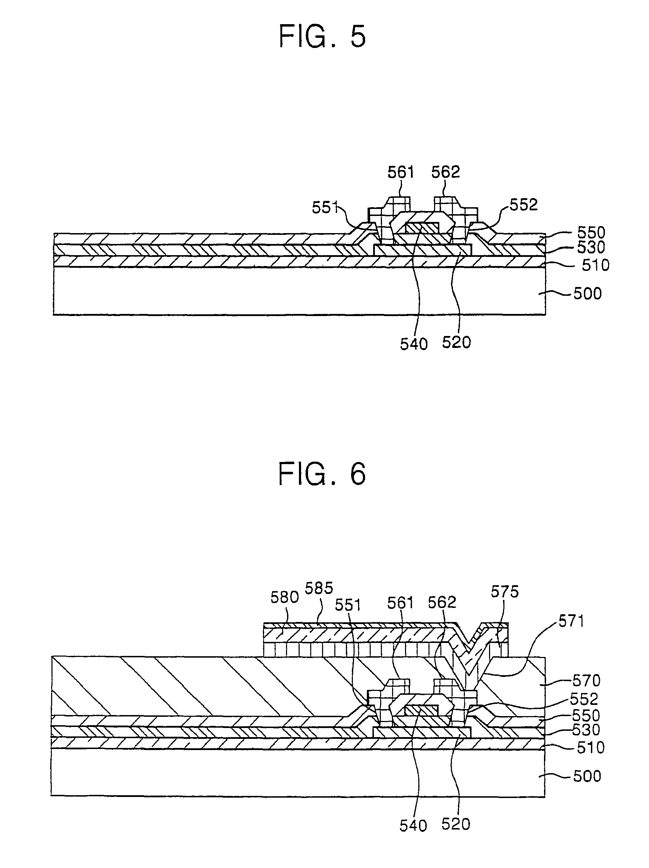

Then, FIGS. 5 to 7 are cross-sectional views of an organic light emitting device 650 constructed as a second exemplary embodiment of the principles of the present invention.

Referring to FIG. 5, a substrate 500 is provided. Substrate 500 may be an insulating glass, conductive, or plastic substrate. A buffer layer 510 is formed on substrate 500. Buffer layer 510 may be a silicon oxide layer, a silicon nitride layer or a combination of these layers. A semiconductor layer 520 is formed on buffer layer 510, and may be made from amorphous silicon or polycrystalline silicon into which amorphous silicon is crystallized.

A gate insulating layer 530 is formed on the entire surface of substrate 500. Gate insulating layer 530 may be a silicon oxide layer, a silicon nitride layer or a combination of these layers.

Then, a gate electrode 540 is formed on gate insulating layer 530 to correspond to a portion of semiconductor layer 520. Gate electrode 540 may be made from Al, Cu, Cr, or so forth. An interlayer insulating layer 550 is formed on the entire surface of substrate 500. Interlayer insulating layer 550 may be a silicon oxide layer, a silicon nitride layer or a combination of these layers.

Interlayer insulating layer 550 and gate insulating layer 530 are etched to form contact holes 551 and 552 exposing semiconductor layer 520. Then, source and drain electrodes 561 and 562 are formed on interlayer insulating layer 550. Source and drain electrodes 561 and 562 may be made from materials selected from the group of Mo, Cr, Al, Ti, Au, Pd and Ag. Also, source and drain electrodes 561 and 562 are connected to semiconductor layer 520 through contact holes 551 and 552, respectively.

Referring to FIG. 6, a planarization layer 570 is formed on the entire surface of substrate 500. Planarization layer 570 may be made from materials selected from the group of polyacrylates resin, epoxy resin, phenolic resin, polyamides resin, polyimides resin, unsaturated polyesters resin, poly(phenylenethers) resin, poly(phenylenesulfides) resin, and benzocyclobutene (BCB).

Further, planarization layer 570 includes a via hole 571 exposing one of source and drain electrodes 561 and 562.

A transparent conductive material is stacked on planarization layer 570, and then patterned to form an auxiliary electrode layer 575 for forming an ohmic contact to one of source and drain electrodes 561 and 562. Thereby, contact properties between an anode 580 to be formed and source and drain electrodes 561 and 562 may be improved. Here, auxiliary electrode layer 575 may be made from one selected from the group of ITO, IZO and ZnO.

Subsequently, a conductive material is stacked on auxiliary electrode layer 575 and patterned to form an anode 580. Anode 580 may be made from a metal as a conductive material with reflective properties, and may be made from materials selected from the group of Ag, an Ag alloy, Al, an Al alloy, Au, Pt, Cu and Sn.

Here, anode 580 may be formed by sputtering. Anode 580 may be formed to a thickness between approximately 500 Å and approximately 2000 Å in order to have appropriate reflective properties. When the thickness of anode 580 is less than 500 Å, it cannot have appropriate reflective properties, whereas when the thickness of anode 580 is greater than 2000 Å, film stress increases and adhesion between anode 580 and an organic layer 600 subsequently stacked on anode 580 or between anode 580 and planarization layer 570 disposed under anode 580 is lowered.

The present invention, however, uses an anode 580 with reflective properties, which cannot satisfy a work function condition capable of working as an anode.

For this reason, in order to increase the work function of anode 580 with reflective properties, anode 580 is surface-treated in the present invention.

Here, like in the first embodiment, anode 580 is surface-treated by a plasma method using CF₃ gas or SF₆ gas containing fluorine.

When anode 580 is surface-treated by the plasma method using CF₃ gas or SF₆ gas containing fluorine, a metal fluoride layer 585 is formed on the surface of anode 580. Here, a molecule constituting metal fluoride layer 585 has a dipole moment by covalent-bonding between metal atoms and fluoride atoms. The dipole moment have an orientation from a positive pole to a negative pole, thereby effectively lowering hole injection barriers. Fluoride is a material with a large dipole moment, so CF₃ gas or SF₆ gas containing fluorine can be used as a source of the plasma method.

In this case, metal fluoride layer 585 is formed to a thickness between approximately 1 nm to approximately 1.5 nm. When the thickness of metal fluoride layer 585 is 1 nm or less, injected charges cannot tunnel through metal fluoride layer 585, whereas when the thickness of metal fluoride layer 585 is 1.5 nm or more, the injected charges can tunnel metal fluoride layer 585, but driving voltage increases.

Thus, when anode 580 is surface-treated by the plasma method using CF₃ gas or SF₆ gas containing fluorine having a large dipole moment, hole injection barriers between anode 580 and a hole injection layer are lowered and thus holes can easily move.

Therefore, when anode 580 is surface-treated by the plasma method using CF₃ gas or SF₆ gas containing fluorine, a single metal layer can be used as an anode, thereby improving luminous efficiency.

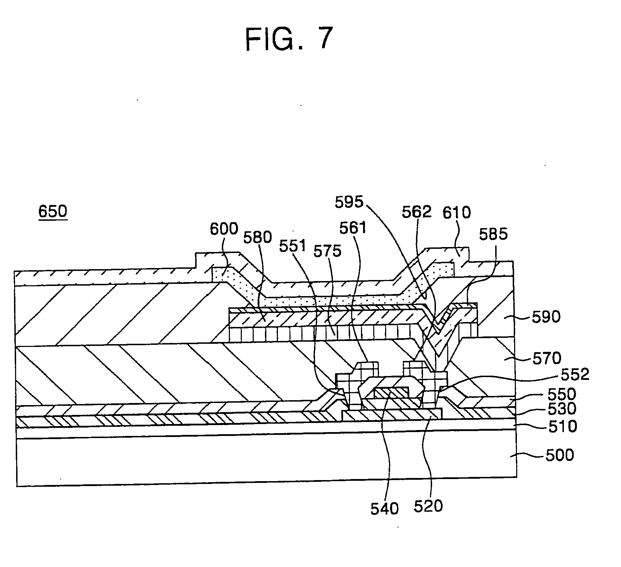

Referring to FIG. 7, a pixel defining layer 590 is formed on the entire surface of substrate 500. Pixel defining layer 590 may be made from one selected from the group of polyacrylates resin, epoxy resin, phenolic resin, polyamides resin, polyimides resin, unsaturated polyesters resin, poly(phenylenethers) resin, poly(phenylenesulfides) resin, and benzocyclobutene (BCB). Here, an opening 595 is formed to expose anode 580.

Then, an organic layer 600 is formed on anode 580 exposed by opening 595 of pixel defining layer 590. Organic layer 600 is constructed with at least an emission layer, and may further include a hole injection layer, a hole transport layer, an electron transport layer or an electron injection layer.

A cathode 610 is formed on the entire surface of substrate 500. Cathode 610 may be made from materials selected from the group of Al, Ag, Na, Au, Ca and Cr.

Therefore, when anode 580 is surface-treated by the plasma method using CF₃ gas or SF₆ gas containing fluorine, a single metal layer can be used as an anode, thereby improving luminous efficiency.

Consequently, according to an organic light emitting device and a method of fabricating the same of the present invention, which has an upper emission structure, an anode can be made of a single metal layer, thereby improving luminous efficiency.

Although the present invention has been described with reference to certain exemplary embodiments thereof, it will be understood by those skilled in the art that a variety of modifications and variations may be made to the present invention without departing from the scope of the present invention defined in the appended claims, and their equivalents.

## Claims

1. An organic light emitting device, comprising:
a substrate;
an anode disposed on the substrate and including a metal;
a metal fluoride layer disposed on the anode;
an organic layer disposed on the metal fluoride layer and including at least an organic emission layer; and
a cathode disposed on the organic layer.

2. a device according to claim 1, with the anode further comprising an auxiliary electrode layer for making an ohmic contact to one of source and drain electrodes.

3. a device according to claim 2, with the auxiliary electrode layer being made from a material selected from the group of indium tin oxide (ITO), indium zinc oxide (IZO) and zinc oxide (ZnO).

4. a device according to any preceding claim, with the metal being a material selected from the group of Ag, an Ag alloy, A1, an A1 alloy, Au, Pt, Cu and Sn.

5. The device according to any preceding claim, with the anode being formed to have a thickness between approximately 500 Å and approximately 2000 Å.

6. A device according to any preceding claim, with the metal fluoride layer being formed to a thickness between approximately 1 nm and approximately 1.5 nm.

7. A method of fabricating an organic light emitting device, comprising:
preparing a substrate;
forming an anode on the surface;
treating a surface of the anode and forming a metal fluoride layer thereon;
forming an organic layer including at least an organic emission layer on the metal fluoride layer; and
forming a cathode on the organic layer.

8. A method according to claim 7, wherein before the formation of the anode, an auxiliary electrode layer is formed for making an ohmic contact to one of source and drain electrodes.

9. A method according to claim 8, with the auxiliary electrode layer being made from a material selected from the group of indium tin oxide (ITO), indium zinc oxide (IZO) and zinc oxide (ZnO).

10. A method according to claim 7, 8 or 9, with the surface treatment of the anode being performed using a plasma method.

11. A method according to claim 10, with the plasma method using CF₃ gas or SF₆ gas as a source.

12. A method according to one of claims 7 to 11, with the anode being made from a material selected from the group of Ag, an Ag alloy, A1, an A1 alloy, Au, Pt, Cu and Sn.
